# EUROPEAN PATENT SPECIFICATION

(11) **EP 2 560 470 B1**
(45) Date of publication and mention of the grant of the patent: **23.03.2016**
(21) Application number: 12165308.3
(22) Date of filing: 24.04.2012
(51) Int. Cl.: H05K 7/14

(54) **Slide assembly with positioning device**
Schiebeanordnung mit Positionierungsvorrichtung
Ensemble coulissant pour dispositif de positionnement

(30) Priority: 19.08.2011 TW 100129887
(43) Date of publication of application: 20.02.2013
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- DE-U1- 20 116 057
- US-B1- 6 454 372

## Description

The present invention relates to a slide assembly with a positioning device, and more particularly, to a bearing assembly which is moved to a pre-set position by an engaging member when the second rail is pulled out relative to the first rail, and the second rail is engaged with the first rail.

### BACKGROUND OF THE INVENTION

The conventional rails are used to the drawers of furniture or the chassis on the computer rack so as to support the slide of the drawer or the chassis. Generally, the bearing assembly includes a plurality of bearings which allow the rails to be easily pulled relative to another. However, when the rails are pulled to a distance, the portions of the rails that are not overlapped to each other cannot retain the bearings therein, so that the conventional bearing assembly has a bearing retainer to retain the bearings. The bearing retainer separates the bearings so that the bearings are not in contact with each other.

The bearing assembly provides the sliding action between the rails and must include a stop base to avoid the bearing assembly from dropping from the rails. Therefore, the rails have a stop base to stop the bearing assembly and the front end of the rails is used to support the inner rail that is pulled out from the outer rail.

As for the minimum distance and the maximum distance between the two rails to be retracted or expanded, the two-section rails and the bearing assembly are free to slide. When retracting the rails, the rails are pushed to the very end and the bearing assembly is always located between the rails. However, when the rails are pulled to the extreme expanding position, the bearing assembly is shifted by the friction of the inner rail so that it may not move to a desired position. In other words, the bearing assembly does not move to the maximum distance with the inner rail, the bearing assembly is stopped by the stop base when it moves to the maximum distance. When the rails are retracted at the status that the bearing assembly does not move to the maximum distance, the bearing assembly will return to its retraction position where the inner rail that not yet reach the desired position will contact the bearings. This makes the movement not smooth as expected. Besides, if the bearing assembly is not moved to the desired position, the connection of exterior equipment to the inner rail is affected.

Furthermore, for the inner rail detachable slide assembly, the inner rail is able to be pulled out from the bearing assembly and separated from the stop base. When the inner rail is to be inserted into the slide assembly and engaged with the bearing assembly from the position where the stop base is located, the bearing assembly has to be in contact with the stop base, such that the inner rail is guided by the stop base to precisely engage with the bearing assembly.

In addition, for the conventional slide assembly, in order to prevent the inner rail from being dropping and retracted when the inner rail is pulled, there is an engaging mechanism located between the inner rail and the stop base. Nevertheless, the engaging mechanism and the movement of the bearing assembly are related to each other. However, under the consideration of reducing manufacturing cost and reducing the number of parts, the above-mentioned mechanism is needed to be improved.

US 6,454,372 B1 discloses a drawer rail which includes an outer rail fixed to ta furniture item, a sliding rail slidably contained in the outer rail, a ball rail slidably contained in the sliding rail, and an inner rail slidably contained in the outer rail and fixed to the drawer or a keyboard supporter. The sliding rail has a front end extending towards an outermost side of the drawer by which it is pulled outward. An elastic arched plate serves as a positioning device and is fixed on the sliding rail near the front end of the sliding rail. However, there is still a need for improving the stability and accuracy of the positioning effect for the inner rail.

DE 201 16 057 U1 discloses a rail system with a first rail and a second rail, wherein the second rail is slidably arranged in the first rail and a positioning element is disposed between the first and the second rail. However, there is still a need for improving the stability and accuracy of the positioning effect for the second rail.

The present invention intends to provide a positioning device that improves the inherent shortcoming which is that the bearing assembly is not moved to a desired position when the inner rail is pulled.

### SUMMARY OF THE INVENTION

The primary object of the present invention is to provide a positioning device for a slide assembly, when the second rail is pulled relative to the first rail, the second rail and the bearing assembly are moved relative to the first rail, and the engaging member on the second rail drives the bearing assembly to continuously move to a desired position. The engaging member makes the second rail be engaged with the first rail.

The present invention relates to a slide assembly and comprises a first rail which includes a path defined along the longitudinal direction of the first rail. An opening is located adjacent to an end of the first rail and a stop face is defined on a wall of the opening. A second rail is movably located in the path of the first rail and extendable through the end with the opening. A bearing assembly is located between the first and second rails. The bearing assembly has a bearing retainer which has a first contact portion. A stop base is located between the first and second rails. The stop base is located adjacent to the opening of the first rail and corresponding to the bearing assembly. An engaging member has a fixing potion, a resilient portion, a second contact portion and an engaging portion, wherein the fixing portion is fixed to the second rail. The resilient portion extends longitudinally from the fixing portion and is bent an angle relative to the fixing portion. The second contact portion extends transversely from the fixing portion and is located corresponding to the first contact portion of the bearing retainer. The engaging portion extends from the resilient portion and moves toward the first rail by the resilient portion.

When the second rail is pulled relative to the first rail, the bearing retainer is moved with the second rail by engagement between the first contact portion and the second contact portion. When the second rail moves to a position relative to the first rail, the engaging portion of the engaging member contacts the stop face of the first rail.

Preferably, the first rail has a stop wall located adjacent to the opening, so that when the second rail is moved to the position relative to the first rail, the second contact portion of the engaging member contacts the stop wall of the first rail.

Preferably, the engaging portion of the engaging member protrudes toward the first rail and includes a contact end and a first inclined guiding portion. The contact end faces the fixing portion and the first inclined guiding portion is located opposite to the contact end. A second inclined guiding portion extends from the contact end and reaches the resilient portion. The stop face of the first rail has a recess which communicates with the opening and the second inclined guiding portion is inserted into the recess.

Preferably, the engaging member has a third inclined guiding portion which extends from the resilient portion and bends toward the second rail.

Preferably, the second rail has a through hole which is located corresponding to the third inclined guiding portion.

Preferably, a pressing member is engaged with the opening of the first rail. The pressing member is pushed to contact the engaging member so as to move the engaging portion away from the stop face of the first rail.

Preferably, the pressing member is connected to the stop base.

Preferably, the pressing member has two wings which contact an inside wall of the opening.

The present invention provides another embodiment of the slide assembly and comprises a first rail including a path defined along the longitudinal direction of the first rail. An opening is located adjacent to an end of the first rail and a stop wall is located adjacent to the opening. A second rail is movably located in the path of the first rail and extendable through the end with the opening. A stop base is located between the first and second rails. The stop base is located adjacent to the opening of the first rail and corresponding to the bearing assembly. A bearing assembly is located between the first and second rails. The bearing assembly has a bearing retainer which has a first contact portion. An engaging member has a fixing potion and a second contact portion, wherein the fixing portion is fixed to the second rail. The second contact portion extends transversely from the fixing portion and is located corresponding to the first contact portion of the bearing retainer. When the second rail is pulled relative to the first rail, the bearing retainer contacts the second contact portion of the engaging member by the first contact portion. When the second rail moves to a position relative to the first rail, the second 6 contact portion of the engaging member contacts the stop wall of the first rail. The first contact portion of the bearing retainer moves to the stop wall.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the slide assembly of the present invention;
Fig. 2 shows the relationship of the first and second rails of the slide assembly of the present invention;
Fig. 3 shows that when the second rail is pulled relative to the first rail, the third inclined guiding portion of the engaging member slides and contacts the second end of the bearing retainer;
Fig. 4 shows that when the second rail is further pulled relative to the first rail, the first inclined guiding portion of the engaging member slides and contacts the second end of the bearing retainer;
Fig. 5 shows that when the second rail is retracted relative to the first rail, the second inclined guiding portion of the engaging member slides and contacts the first end of the bearing retainer;
Fig. 6 shows that the pressing member includes two wings which contact an inside wall of the opening of the first rail;
Fig. 7 shows that when the second rail is pulled relative to the first rail, the bearing retainer is stopped by the engaging member and co-moved with the second rail;
Fig. 8 shows the top view of the relationship of the engaging member and the first rail when the second rail is pulled to a position relative to the first rail;
Fig. 9 shows the side view of the relationship of the engaging member and the first rail when the second rail is pulled to a position relative to the first rail;
Fig. 10 shows that when the second rail is pulled to a position relative to the first rail and then the second rail is retracted a small distance, the contact end of the engaging member contacts the stop face of the first rail;
Fig. 11 shows that the contact end of the engaging member is disengaged from the stop face of the first rail, and
Fig. 12 shows that when the second rail is pulled to a position relative to the first rail, one of the notches of the bearing retainer is located corresponding to one of the installation holes of the second rail.

### DETAILED DESCRIPTION OF THE PREFERRED EMBODIMENT

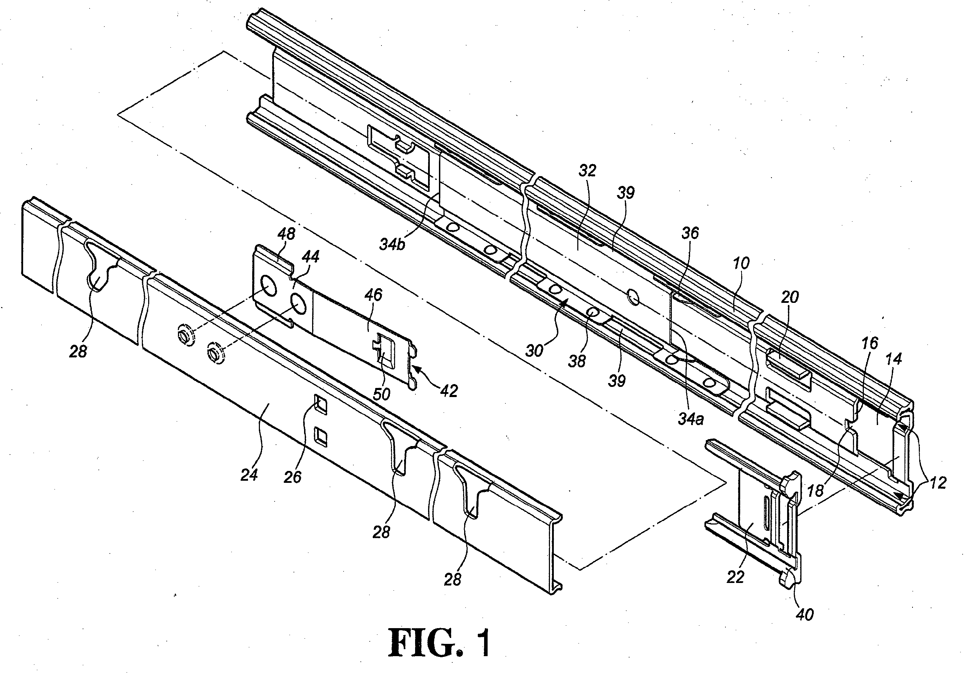

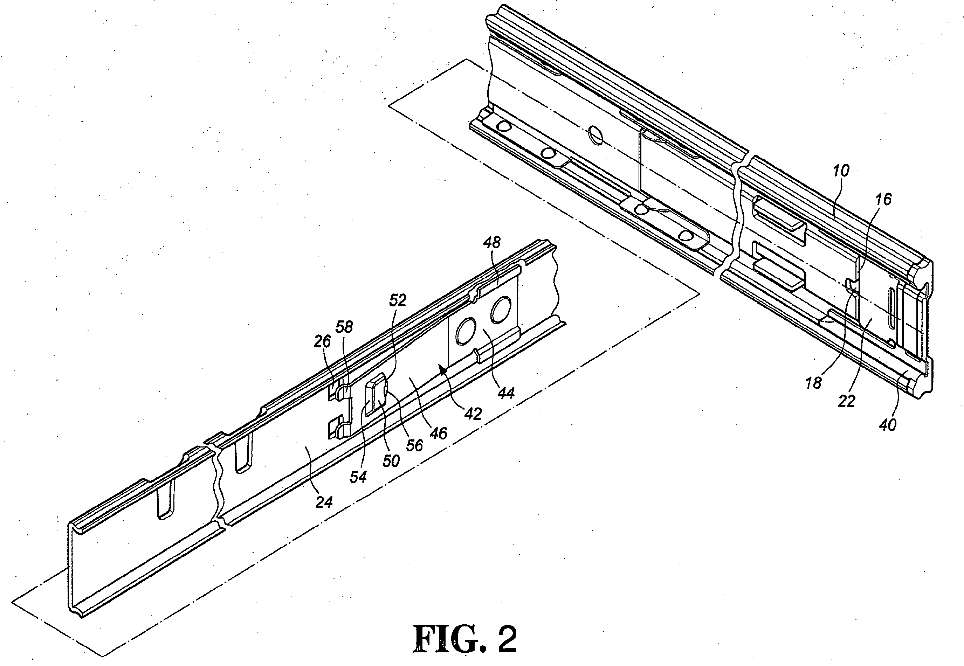

Referring to Figs. 1 and 2, the slide assembly of the present invention comprises a first rail 10, a pressing member 22, a second rail 24, a bearing assembly 30, a stop base 40 and an engaging member 42.

The first rail 10 includes a path 12 defined along the longitudinal direction of the first rail 10 and an opening 14 is located adjacent to an end of the first rail 10. A stop face 16 is defined on a wall of the opening 14. The stop face 16 of the first rail 10 has a recess 18 which communicates with the opening 14 and a stop wall 20 is located adjacent to the opening 14.

The pressing member 22 is engaged with the opening 14 of the first rail 10.

The second rail 24 is movably located in the path 12 of the first rail 10 and may extend through the end with the opening 14. The second rail 24 has at least one through hole 26, and multiple installation holes 28 are located along the length of the second rail 24. The installation holes 28 are connected with an exterior object such as posts of a chassis (not shown).

The bearing assembly 30 is located between the first and second rails 10, 24, and the bearing assembly 30 has a bearing retainer 32 which has a first end 34a, a second end 34b, a first contact portion 36 and multiple bearings 38. The second end 34b is located corresponding to the first end 34a. The bearings 38 make the second rail 24 slide easily relative to the first rail 10. Preferably, the bearing retainer 32 includes multiple equally spaced notches 39.

The stop base 40 is located between the first and second rails 10, 24, and the stop base 40 is located adjacent to the opening14 of the first rail 10 and corresponding to the bearing assembly 30. When the second rail 24 is pulled to a pre-set position relative to the first rail 10, the bearing retainer 32 of the bearing assembly 30 contacts the stop base 40.

The engaging member 42 has a fixing potion 44, a resilient portion 46, a second contact portion 48 and an engaging portion 50. The fixing portion 44 is fixed to the second rail 24. The resilient portion 46 extends longitudinally from the fixing portion 44 and is bent an angle relative to the fixing portion 44. The second contact portion 48 extends transversely from the fixing portion 44 and is located corresponding to the first contact portion 36 of the bearing retainer 32. The engaging portion 50 extends from the resilient portion 46 and protrudes toward the first rail 10. The protruding engaging portion 50 has a contact end 52 extending toward the fixing portion 44. The engaging portion 50 moves toward the first rail 10 by the force of the resilient portion 46.

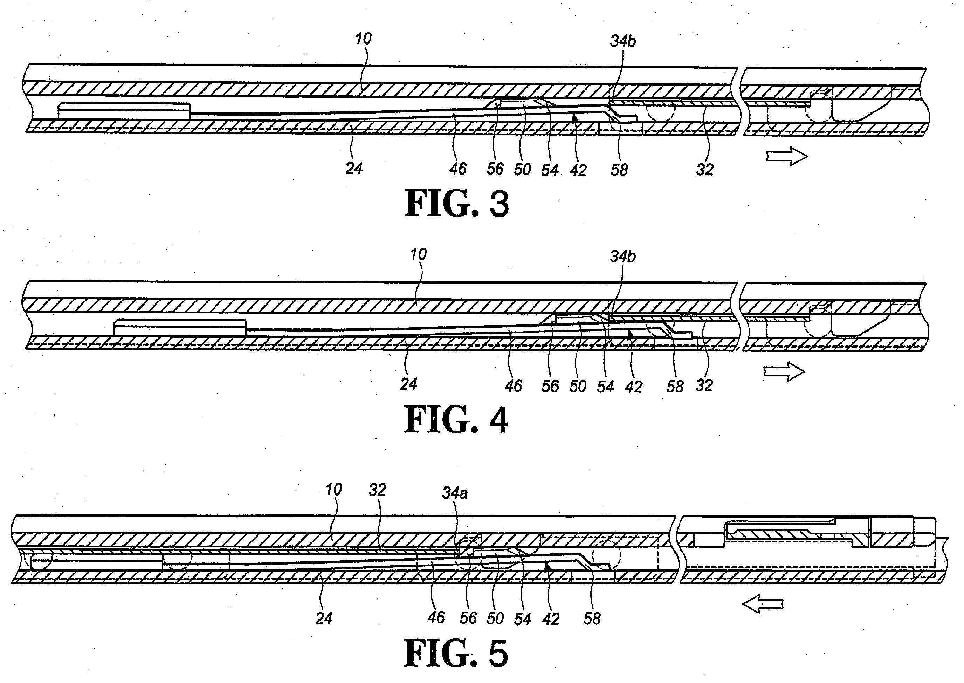

In this embodiment, the engaging member 42 has a first inclined guiding portion 54, a second inclined guiding portion 56 and a third inclined guiding portion 58. The first inclined guiding portion 54 is located opposite to the contact end 52 and the second inclined guiding portion 56 extends from the contact end 52 and reaches the resilient portion 46. The third inclined guiding portion 58 extends from the resilient portion 46 and bends toward the second rail 24. The through hole 26 is located corresponding to the third inclined guiding portion 58. By the first, second and third inclined guiding portions 54, 56, 58, when the engaging member 42 slides and contacts the first rail 10 and about to pass the first end 34a of the bearing retainer 32 or the second end 34b of the bearing retainer 32, as shown in Figs. 3 to 5, the first, second and third inclined guiding portions 54, 56, 58 can slide over the ends 34a, 34b of the bearing retainer 32. The ends of the engaging member 42 and the engaging portion 50 are not stopped by the bearing retainer 32, so that the second rail 24 can be smoothly moved relative to the first rail 10.

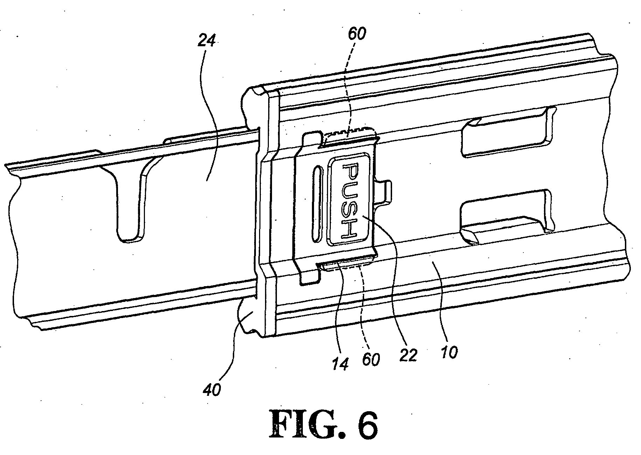

The pressing member 22 is preferably connected to the stop base 40 and located corresponding to the opening 14 of the first rail 10. The pressing member 22 has two wings 60 which contact an inside wall of the opening 14 as shown in Fig. 6. Therefore, the pressing member 22 can only be moved in one direction relative to the opening 14. In this embodiment, when the pressing member 22 is pressed, it can only move toward the second rail 24.

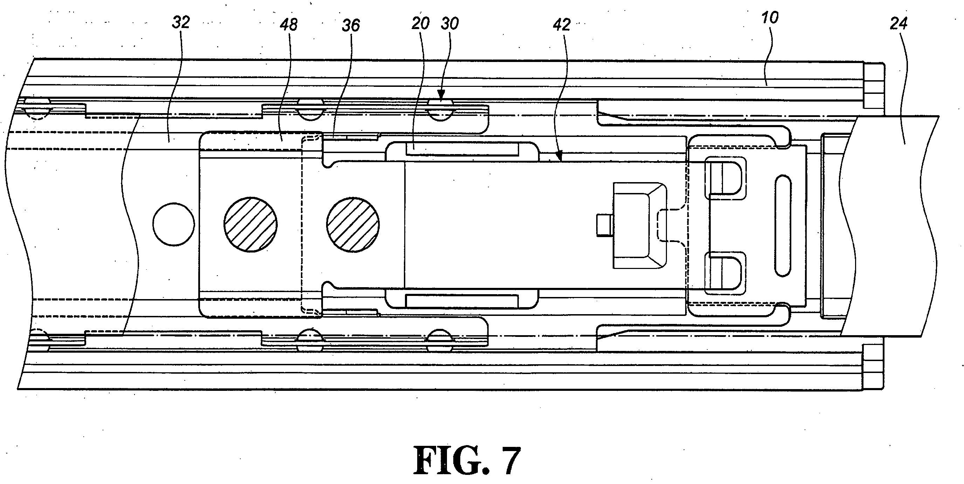

As shown in Fig. 7, when the second rail 24 is pulled relative to the first rail 10, if the bearing retainer 32 of the bearing assembly 30 is not moved with the movement of the second rail 24 relative to the first rail 10 and is moved to a pre-set position, by the contact between the second contact portion 48 of the engaging member 42 and the first contact portion 36 of the bearing retainer 32, the bearing retainer 32 can be moved with the movement of the second rail 24 relative to the first rail 10 and is continuously pulled.

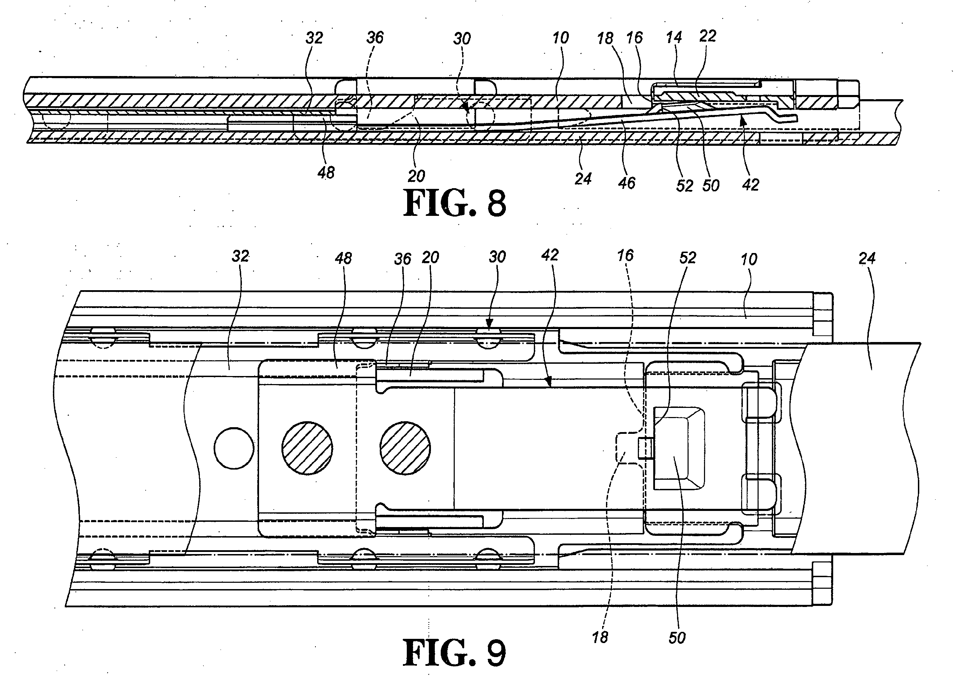

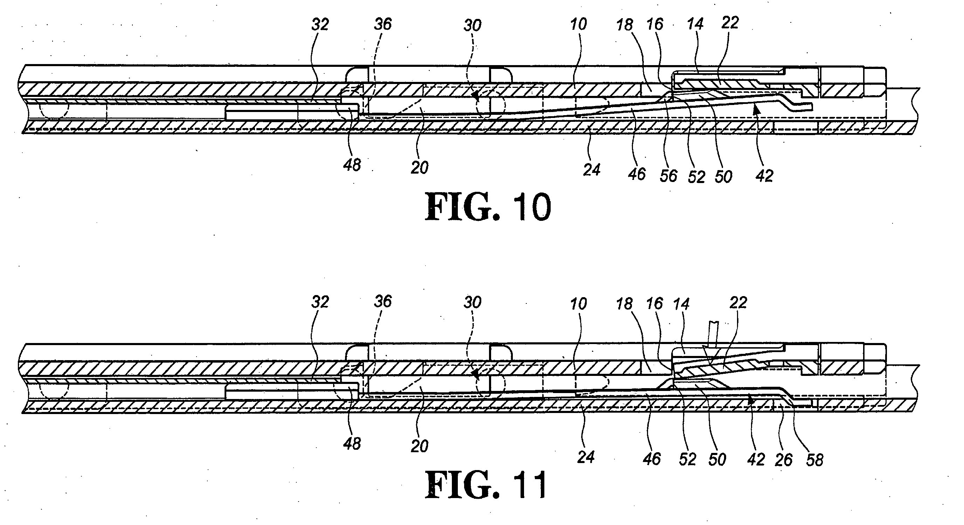

As shown in Figs. 8 and 9, when the second rail 24 is further pulled relative to the first rail 10 and moved to a position relative to the first rail 10, the second contact portion 48 of the engaging member 42 contacts the stop wall 20 of the first rail 10, so that the second rail 24 is not drop from the first rail 10. In the meanwhile, the first contact portion 36 of the bearing retainer 32 is moved by the second contact portion 48 of the engaging member 42 so that the first contact portion 36 of the bearing retainer 32 is moved to the stop wall 20 of the first rail 10. Besides, the engaging portion 50 of the engaging member 42 is released by the force of the resilient portion 46 so that the contact end 52 is located corresponding to the stop face 16 of the first rail 10. As shown in Figs. 8 and 10, when the second contact portion 48 of the engaging member 42 contacts the stop wall 20 of the first rail 10, the contact end 52 of the engaging portion 50 is located at a small distance from the stop face 16 to ensure that the contact end 52 will first move over the stop face 16. And the second rail 24 is retracted a small distance relative to the first rail 10, the contact end 52 of the engaging portion 50 contacts the stop face 16 again. Therefore, the second rail 24 cannot be retracted relative to the first rail 10. When the contact end 52 of the engaging portion 50 contacts the stop face 16, the second inclined guiding portion 56 extends through the recess 18 of the first rail 10 while the contact between the contact end 52 and the stop face 16 is not affected.

When releasing the contact end 52 from the stop face 16, as shown in Fig. 11, the user presses the pressing member 22 by a finger, the pressing member 22 pushes the engaging portion 50 of the engaging member 42, so that the contact end 52 of the engaging portion 50 is disengaged from the stop face 16 of the first rail 10. The third inclined guiding portion 58 can be inserted into the through hole 26 of the second rail 24 to release the engaging member 42 and the second rail 24. The second rail 24 is able to be retracted into the path 12 of the first rail 10.

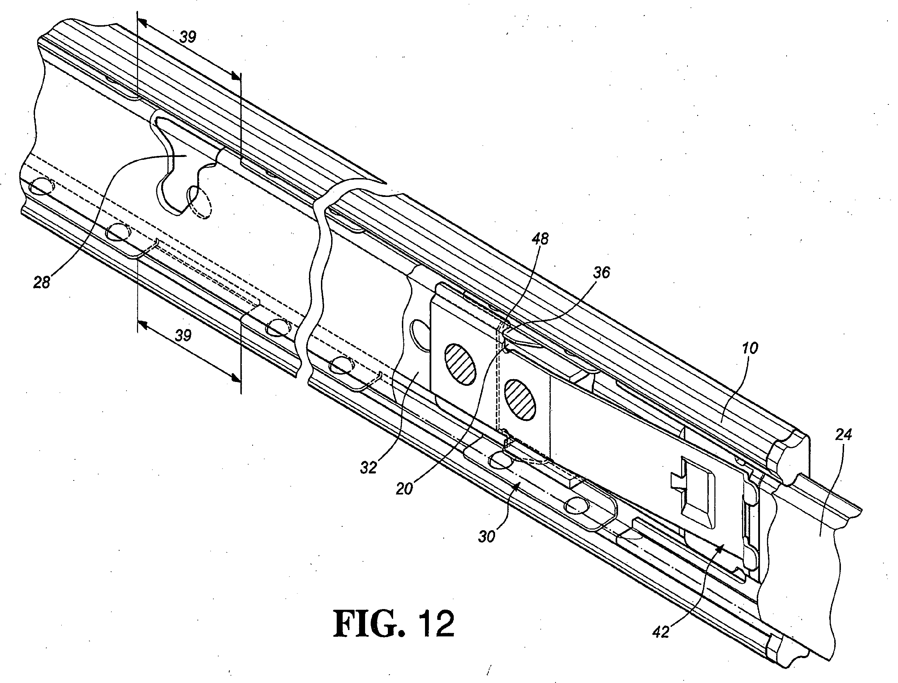

It is noted that as shown in Fig. 12, the pre-set position of the bearing retainer 32 of the bearing assembly 30 is that when the first contact portion 36 of the bearing retainer 32 moves to the stop wall 20 of the first rail 10 to let one of the notches 39 of the bearing retainer 32 be located corresponding to one of the installation holes 28 of the second rail 24. Therefore, by the contact between the second contact portion 48 of the engaging member 42 and the first contact portion 36 of the bearing retainer 32, the bearing retainer 32 is moved with the second rail 24 and moved to the above-mentioned pre-set position. Therefore, when mounting members of the exterior object are connected to the installation holes 28, the bearing retainer 32 does not interfere with the installation.

While we have shown and described the embodiment in accordance with the present invention, it should be clear to those skilled in the art that further embodiments may be made without departing from the scope of the present invention.

## Claims

1. A slide assembly comprising:
a first rail (10) including a path (12) defined along a longitudinal direction of the first rail (10), an opening (14) located adjacent to an end of the first rail (10) and a stop face (16) defined on a wall of the opening (14);
a second rail (24) movably located in the path (12) of the first rail (10) and extendable through the end with the opening (14);
a bearing assembly (30) located between the first and second rails (10, 24), the bearing assembly (30) having a bearing retainer (32) which has a first contact portion (36);
a stop base (40) located between the first and second rails (10, 24), the stop base (40) located adjacent to the opening (14) of the first rail (10) and corresponding to the bearing assembly (30); and
an engaging member (42) having a fixing potion (44), a resilient portion (46), a second contact portion (48) and an engaging portion (50), the fixing portion (44) fixed to the second rail (24), the resilient portion (46) extending longitudinally from the fixing portion (44) and being bent an angle relative to the fixing portion (44), the second contact portion (48) extending transversely from the fixing portion (44) and located corresponding to the first contact portion (36) of the bearing retainer (32), the engaging portion (50) extending from the resilient portion (46) and moving toward the first rail (10) by the resilient portion (46);
wherein when the second rail (24) is pulled relative to the first rail (10), the bearing retainer (32) is moved with the second rail (24) by engagement between the first contact portion (36) and the second contact portion (48);
wherein when the second rail (24) moves to a position relative to the first rail (10), the engaging portion (50) of the engaging member (42) contacts the stop face (16) of the first rail (10).

2. The slide assembly as claimed in claim 1, wherein the first rail (10) has a stop wall (20) located adjacent to the opening (14), so that when the second rail (24) is moved to the position relative to the first rail (10), the second contact portion (48) of the engaging member (42) contacts the stop wall (20) of the first rail (10).

3. The slide assembly as claimed in claim 1, wherein the engaging portion (50) of the engaging member (42) protrudes toward the first rail (10) and includes a contact end (52) and a first inclined guiding portion (54), the contact end (52) faces the fixing portion (44) and the first inclined guiding portion (54) located opposite to the contact end (52), a second inclined guiding portion (56) extends from the contact end (52) and reaches the resilient portion (46), the stop face (16) of the first rail (10) has a recess (18) which communicates with the opening (14) and the second inclined guiding portion (56) is inserted into the recess (18).

4. The slide assembly as claimed in claim 1, wherein the engaging member (42) has a third inclined guiding portion (58) which extends from the resilient portion (46) and bends toward the second rail (24).

5. The slide assembly as claimed in claim 4, wherein the second rail (24) has a through hole (26) which is located corresponding to the third inclined guiding portion (58).

6. The slide assembly as claimed in claim 1, further comprising a pressing member (22) engaged with the opening (14) of the first rail (10), wherein the pressing member (22) is pushed to contact the engaging member (42) so as to move the engaging portion (50) away from the stop face (16) of the first rail (10).

7. The slide assembly as claimed in claim 6, wherein the pressing member (22) is connected to the stop base (40).

8. The slide assembly as claimed in claim 6, wherein the pressing member (22) has two wings (60) which contact an inside wall of the opening (14).

## Patentansprüche

1. Ein Gleitmechanismus, umfassend:
einer ersten Schiene (10) mit einem Durchlass (12), der einer Längsrichtung der ersten Schiene (10) entlang gebildet ist und eine Öffnung (14) angrenzend zu einem Ende der ersten Schiene (10) sowie ein Anschlag (16) an einer Wand der Öffnung (14) gebildet sind;
einer zweiten Schiene (24), die beweglich im Durchlass (12) der ersten Schiene (10) angeordnet ist und sich durch das Ende mit der Öffnung (14) ausstrecken läßt;
einem Lager (30), das zwischen den ersten und zweiten Schienen (10, 24) angeordnet und das Lager (30) mit einer Lagerbefestigung (32) mit einem ersten Kontaktteil (36) gebildet ist;
einer Anschlagbasis (40), die zwischen den ersten und zweiten Schienen (10, 24) und die Anschlagbasis (40) angrenzend zur Öffnung (14) der ersten Schiene (10) und in Übereinstimmung mit dem Lager (30) angeordnet ist; und
einem Einrückteil (42) mit einem Befestigungsteil (44), einem flexiblen Teil (46), einem zweiten Kontaktteil (48) und einem Eingriffen (50), wobei das Befestigungsteil (44) an der zweiten Schiene (24) befestigt ist, sich das flexible Teil (46) der Länge nach vom Befestigungsteil (44) erstreckt und in einem Winkel relativ zum Befestigungsteil (44) gebogen ist, sich das zweite Kontaktteil (48) quer vom Befestigungsteil (44) erstreckt und in Übereinstimmung mit dem ersten Kontaktteil (36) der Lagerbefestigung (32) angeordnet ist, sich das Eingriffteil (50) vom flexiblen Teil (46) erstreckt und mit dem flexiblen Teil (46) zur ersten Schiene (10) verschoben wird;
wobei beim Ziehen der zweiten Schiene (24) in der ersten Schiene (10) die Lagerbefestigung (32) mit der zweiten Schiene (24) durch das Eingreifen des ersten Kontaktteils (36) in das zweite Kontaktteil (48) verschoben wird;
wobei beim Verschieben der zweiten Schiene (24) in eine Position in der ersten Schiene (10) das Eingriffteil (50) des Einrückteils (42) mit dem Anschlag (16) der ersten Schiene (10) in Berührung kommt.

2. Der Gleitmechanismus nach Anspruch 1, wobei die erste Schiene (10) mit einer Anschlagwand (20) angrenzend zur Öffnung (14) gebildet ist, so das beim Verschieben der zweiten Schiene (24) in einer Position in der ersten Schiene (10) das zweite Kontaktteil (48) des Einrückteils (42) mit der Anschlagwand (20) der ersten Schiene (10) in Berührung kommt.

3. Der Gleitmechanismus nach Anspruch 1, wobei das Eingriffteil (50) des Einrückteils (42) zur ersten Schiene (10) vorsteht und mit einer Kontaktfläche (52) und mit einem ersten geneigten Führungsteil (54) gebildet ist, die Kontaktfläche (52) dem Befestigungsteil (44) gegenüber und das erste geneigte Führungsteil (54) gegenüber der Kontaktfläche (52) gebildet ist, sich ein zweites geneigtes Führungsteil (56) von der Kontaktfläche (52) zum flexiblen Teil (46) erstreckt, der Anschlag (16) der ersten Schiene (10) eine Aussparung (18) aufweist, die mit der Öffnung (14) verbunden ist und das zweite geneigte Führungsteil (56) in die Aussparung (18) eingesetzt ist.

4. Der Gleitmechanismus nach Anspruch 1, wobei das Einrückteil (42) ein drittes geneigtes Führungsteil (58) aufweist, welches sich vom flexiblen Teil (46) erstreckt und zur zweiten Schiene (24) gebogen ist.

5. Der Gleitmechanismus nach Anspruch 4, wobei die zweite Schiene (24) ein durchgehendes Loch (26) in Übereinstimmung mit dem dritten geneigten Führungsteil (58) aufweist.

6. Der Gleitmechanismus nach Anspruch 1, weiter bestehend aus einem Andrückteil (22), das in die Öffnung (14) der ersten Schiene (10) eingerückt ist, wobei dieses Andrückteil (22) angeschoben wird, um mit dem Einrückteil (42) in Berührung zu kommen und um das Eingriffteil (50) vom Anschlag (16) der ersten Schiene (10) wegzubewegen.

7. Der Gleitmechanismus nach Anspruch 6, wobei das Andrückteil (22) mit der Anschlagbasis (40) verbunden ist.

8. Der Gleitmechanismus nach Anspruch 6, wobei das Andrückteil (22) zwei Flügel (60) aufweist, die mit einer Innenwand in der Öffnung (14) in Berührung kommen.

## Revendications

1. Un ensemble coulissant comprenant :
un premier rail (10) comprenant une trajectoire (12) définie le long d'une direction longitudinale du premier rail (10), une ouverture (14) située adjacente à une extrémité du premier rail (10) et une surface de butée (16) définie sur une paroi de l'ouverture (14) ;
un second rail (24) situé de manière mobile dans la trajectoire (12) du premier rail (10) et extensible au travers de l'extrémité avec l'ouverture (14) ;
un ensemble de roulements (30) situés entre les premier et second rails (10, 24), l'ensemble de roulements (30) ayant un arrêtoir de roulement (32) qui a une première partie de contact (36) ;
une embase de butée (40) située entre les premier et second rails (10, 24), l'embase de butée (40) située adjacente à l'ouverture (14) du premier rail (10) et en correspondance avec l'ensemble de roulements (30) ; et
un élément d'engagement (42) ayant une partie de fixation (44), une partie élastique (46), une seconde partie de contact (48) et une partie d'engagement (50), la partie de fixation (44) fixée au second rail (24), la partie élastique (46) s'étendant de manière longitudinale à partir de la partie de fixation (44) et formant un angle par rapport à la partie de fixation (44), la seconde partie de contact (48) s'étendant de manière transversale à partir de la partie de fixation (44) et située en correspondance avec la première partie de contact (36) de l'arrêtoir de roulement (32), la partie d'engagement (50) s'étendant à partir de la partie élastique (46) et se déplaçant vers le premier rail (10) grâce à la partie élastique (46) ;
dans lequel quand le second rail (24) est tiré par rapport au premier rail (10), l'arrêtoir de roulement (32) est déplacé avec le second rail (24) par engagement entre la première partie de contact (36) et la seconde partie de contact (48);
dans lequel quand le second rail (24) se déplace vers une position par rapport au premier rail (10), la partie d'engagement (50) de l'élément d'engagement (42) entre en contact avec la surface de butée (16) du premier rail (10).

2. L'ensemble coulissant selon la revendication 1, dans lequel le premier rail (10) a une paroi de butée (20) située adjacente à l'ouverture (14), de sorte que quand le second rail (24) est déplacé vers la position par rapport au premier rail (10), la seconde partie de contact (48) de l'élément d'engagement (42) entre en contact avec la paroi de butée (20) du premier rail (10).

3. L'ensemble coulissant selon la revendication 1, dans lequel la partie d'engagement (50) de l'élément d'engagement (42) fait saillie vers le premier rail (10) et inclut une extrémité de contact (52) et une première partie inclinée de guidage (54), l'extrémité de contact (52) fait face à la partie de fixation (44) et la première partie inclinée de guidage (54) située à l'opposée de l'extrémité de contact (52), une deuxième partie inclinée de guidage (56) s'étend à partir de l'extrémité de contact (52) et atteint la partie élastique (46), la surface de butée (16) du premier rail (10) a un évidement (18) qui communique avec l'ouverture (14) et la deuxième partie inclinée de guidage (56) est insérée dans l'évidement (18).

4. L'ensemble coulissant selon la revendication 1, dans lequel l'élément d'engagement (42) a une troisième partie inclinée de guidage (58) qui s'étend à partir de la partie élastique (46) et s'incurve vers le second rail (24).

5. L'ensemble coulissant selon la revendication 4, dans lequel le second rail (24) a un trou perforant (26) qui est situé en correspondance avec la troisième partie inclinée de guidage (58).

6. L'ensemble coulissant selon la revendication 1, comprenant en outre un élément de pression (22) engagé avec l'ouverture (14) du premier rail (10), dans lequel l'élément de pression (22) est poussé pour entrer en contact avec l'élément d'engagement (42) de façon à déplacer la partie d'engagement (50) à l'écart de la surface de butée (16) du premier rail (10).

7. L'ensemble coulissant selon la revendication 6, dans lequel l'élément de pression (22) est raccordé à l'embase de butée (40).

8. L'ensemble coulissant selon la revendication 6, dans lequel l'élément de pression (22) a deux ailettes (60) qui sont en contact avec une paroi intérieure de l'ouverture (14).
